# EUROPÄISCHE PATENTSCHRIFT

(11) **EP 3 796 019 B1**
(45) Veröffentlichungstag und Bekanntmachung des Hinweises auf die Patenterteilung: **15.11.2023**
(21) Anmeldenummer: 19198911.0
(22) Anmeldetag: 23.09.2019
(51) Int. Cl.: G01R 33/28, G01R 33/36, G01R 33/341, G01R 33/54

(54) **VERFAHREN UND VORRICHTUNG ZUM ERKENNEN VON DEFEKTEN VERSTIMMSCHALTUNGEN BEI EINEM MAGNETRESONANZTOMOGRAPHEN**
METHOD AND DEVICE FOR DETECTING DEFECTIVE DETUNING CIRCUITS IN MAGNETIC RESONANCE TOMOGRAPHY
PROCÉDÉ ET DISPOSITIF DE DÉTECTION DES CIRCUITS DÉSACCORDEURS DÉFECTUEUX DANS UN TOMOGRAPHE À RÉSONANCE MAGNÉTIQUE

(43) Veröffentlichungstag der Anmeldung: 24.03.2021
(73) Patentinhaber: Siemens Healthcare GmbH, 91052 Erlangen (DE)
(72) Erfinder: Biber, Stephan, 91056 Erlangen (DE)

(56) Entgegenhaltungen:
- EP-A1- 3 287 805
- US-A1- 2009 302 845
- US-A1- 2017 205 481

## Beschreibung

Die Erfindung betrifft ein Verfahren zum Überprüfen einer Verstimmeinrichtung einer Antennenspule eines Magnetresonanztomographen. In dem Verfahren wird mittels eines Empfängers ein Empfangssignal über die Antennenspule empfangen.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Um einen möglichst guten Signal-zu-Rausch-Abstand (Signal-to-Noise Ratio, SNR) zu erzielen, wird versucht, die Antennenspulen für den Empfang möglichst nahe am Patienten anzuordnen. Dies erfolgt mit sogenannten Lokalspulen, die üblicherweise mit Kabelverbindungen an den Magnetresonanztomographen angeschlossen werden. Durch die hohen Felder beim Anregen der Kernspins können defekte Lokalspulen jedoch auch zur Gefahr für den Patienten werden, wenn Schutzvorrichtungen versagen.

Das Dokument US 2017/205481 A1 beschreibt einen Magnetresonanztomographen mit einer Hochfrequenzspule, die ausgelegt ist, ein Hochfrequenzsignal auszusenden und zu empfangen. Eine Verstimmschaltung ist ausgelegt, die Hochfrequenzspule zu verstimmen und abzustimmen und eine Überwachungsschaltung überwacht einen Parameter aus Spannung oder Strom der Verstimmschaltung. Eine Steuerung des Magnetresonanztomographen überwacht anhand des überwachten Parameters nach einem Überwachungsschema, ob die Verstimmschaltung in einem unzulässigen Betriebszustand ist, wobei die Entscheidungskriterien und/oder das Überwachungsschema sich in Abhängigkeit vom Zustand der Verstimmschaltung ändern.

Es stellt sich daher die Aufgabe, die Anwendung der Lokalspulen sicherer zu machen.

Die Aufgabe wird durch das erfindungsgemäße Verfahren nach Anspruch 1, sowie durch das erfindungsgemäße Verfahren nach Anspruch 5 gelöst. Die erfindungsgemäßen Verfahren sind zum Überprüfen einer Verstimmeinrichtung einer Antennenspule eines Magnetresonanztomographen vorgesehen. Bei der Verstimmeinrichtung besteht die Möglichkeit, diese gezielt durch ein Steuersignal zu aktivieren. Dies kann beispielsweise eine Gleichspannung oder ein Gleichstrom sein, der an die Verstimmeinrichtung angelegt wird, wie es bei PIN-Dioden oder Schaltern üblich ist. Das Steuersignal kann aber auch ein anderes analoges oder digitales Signal sein, das in einer Steuereinrichtung der Verstimmeinrichtung zu einem Verstimmen der Antennenspule führt. Als Aktivieren der Verstimmeinrichtung im Sinne der Erfindung wird es im Sinne der Erfindung aber nicht angesehen, wenn ein Signal, insbesondere ein in die Antennenspule induziertes Hochfrequenzsignal, das selbst durch die induzierte Spannung zu einer Gefahr für den Patienten führen könnte, die Verstimmeinrichtung aktiviert, wie es beispielsweise bei einer passiven Sicherung oder Zenerdioden der Fall ist. Vorzugsweise führt die Verstimmeinrichtung zu einer Verschiebung einer Resonanzfrequenz der Antennenspule, wobei ein Empfang eines Hochfrequenzsignals durch einen angeschlossenen Empfänger weiterhin möglich ist. Die Verstimmeinrichtung kann beispielsweise durch kapazitätsveränderliche Dioden oder zuschaltbare Induktivitäten oder Kapazitäten in einem parallel oder Serienresonanzkreis der Antennenspule realisiert sein. Es ist aber denkbar, dass die Verstimmeinrichtung auch eine passive Komponente aufweist, die eine Begrenzung der induzierten Spannung bzw. Stromes vornimmt. Denkbar sind beispielsweise Verstimmdioden, die durch eine induzierte, gleichgerichtete Spannung ohne externes Steuersignal verstimmt werden oder überkreuz geschaltete Dioden bzw. Zenerdioden, die eine induzierte Spannung oberhalb eines Grenzwertes kurzschließen.

In einem Schritt der Verfahren wird die Verstimmeinrichtung der Antennenspule aktiviert, beispielsweise durch Anlegen einer Spannung der eines Stromes oder durch ein anderes Steuersignal an die Steuereinrichtung der Antennenspule.

In einem anderen Schritt empfängt ein Empfänger ein erstes Empfangssignal der Antennenspule mit aktivierter Verstimmeinrichtung. Als Empfangssignal wird hierbei ein hochfrequentes Strom- und/oder Spannungssignal angesehen, das analog oder auch in analoger Weise bearbeitet und/oder digitalisiert den Empfänger erreicht. Erfindungsgemäß weist das Empfangssignal Information zu Amplitude, Phase und/oder spektraler Verteilung auf. Der Empfänger kann dabei ein dedizierter Empfänger zum Prüfen der Verstimmeinrichtung sein, vorzugsweise aber ein Empfänger des Magnetresonanztomographen, der auch zum Empfang von Magnetresonanzsignalen zur Bildgebung von dem Magnetresonanztomographen genutzt wird.

In einem weiteren Schritt wird ein zweites Empfangssignal der Antennenspule mit dem Empfänger empfangen. Dabei kann je nach der Variante des Verfahrens die Verstimmeinrichtung aktiviert sein oder nicht, wie in den nachfolgenden Ansprüchen bzw. Unteransprüchen jeweils ausgeführt wird. Zu dem Empfangssignal und Empfänger gilt das bereits angeführte.

In einem anderen Schritt vergleicht eine Prüfsteuerung das erste Empfangssignal mit dem zweiten Empfangssignal. Die Prüfsteuerung kann dabei beispielsweise die Steuerung des Magnetresonanztomographen oder einer Bildauswertung oder auch ein dedizierter Prozessor sein. Als Vergleichen des ersten und des zweiten Empfangssignal kann beispielsweise eine Differenz- oder Quotientenbildung und Vergleich mit vorbestimmten Differenzwerten bzw. Quotienten oder Relation von mittleren oder maximalen Amplituden oder Energie sein. Vorzugsweise ist der Vergleich dabei nicht auf exakte Werte beschränkt, sondern kann auch durch Wertebereiche definiert sein, die beispielsweise bis zu 5%, 10%, 20 % oder 50% eines der beiden Werte von erstem oder zweitem Empfangssignal breit sind oder bei Quotienten um einen Faktor kleiner als 0,1, 0,2, oder 0,5 von einem Wert 1 abweichen. Auch sind weitere mathematische Berechnungen auf diesen Relationen im Rahmen des Vergleichs denkbar. Beispielhafte Ausführungsformen dazu sind nachfolgend in den Ansprüchen bzw. Unteransprüchen angegeben.

Stimmt das Ergebnis des Vergleichs nicht mit einem vorbestimmten Wertebereich überein, so gibt die Steuerung ein Warnsignal über ein Ausgabegerät an einen Nutzer aus und/oder unterbricht eine weitere Bilderfassung.

Denkbar ist es beispielsweise, dass eine zeitliche Veränderung des Eingangssignals wie eine Dämpfung abhängig von der aktivierten Verstimmeinrichtung ist und so durch den Vergleich der beiden Empfangssignale auf die Funktion der Verstimmeinrichtung geschlossen werden kann. Auf vorteilhafte Weise ermöglicht das erfindungsgemäße Verfahren mit den Mitteln des Magnetresonanztomographen eine schnelle Überprüfung der Verstimmeinrichtung.

Ein erfindungsgemäßer Magnetresonanztomograph ist jeweils in den Ansprüchen 8 und 9 definiert. Der erfindungsgemäße Magnetresonanztomograph weist eine Prüfeinrichtung zum Prüfen einer Verstimmeinrichtung einer Antennenspule des Magnetresonanztomographen mit einer Prüfsteuerung auf. Die Prüfsteuerung kann dabei ein dedizierter Prozessor oder Logikbaustein sein, aber auch ein Prozessor des Magnetresonanztomographen, der durch ein Programm diese Aufgabe neben einer Bilderfassung übernimmt. Die Prüfsteuerung ist ausgelegt ist, die Verstimmeinrichtung der Antennenspule zu aktivieren, ein erstes Empfangssignal mit einem Empfänger zu empfangen, ein zweites Empfangssignal mit dem Empfänger zu empfangen, das erste Empfangssignal mit dem zweiten Empfangssignal zu vergleichen und ein Warnsignal auszugeben, wenn das Ergebnis des Vergleichs nicht mit einer vorbestimmten Relation für das erste Empfangssignals zu dem zweiten Empfangssignal übereinstimmt. Das Warnsignal kann beispielsweise auf einer Anzeige an einen Nutzer ausgegeben werden oder an die Steuerung des Magnetresonanztomographen, um eine weitere Bilderfassung zu stoppen.

Der erfindungsgemäße Magnetresonanztomograph teilt die Vorteile des jeweiligen erfindungsgemäßen Verfahrens. Weitere vorteilhafte Ausführungsformen sind in den Unteransprüchen angegeben.

Im erfindungsgemäßen Verfahren nach Anspruch 1 weist das Verfahren einen Schritt auf, die Verstimmeinrichtung zu deaktivieren. Der Schritt des Empfangens des ersten Empfangssignals erfolgt bei aktivierter Verstimmeinrichtung und der Schritt des Empfangens des zweiten Empfangssignals erfolgt dabei bei abgeschalteter Verstimmeinrichtung. In dem Schritt des Vergleichens wird ein Rauschpegel des ersten Empfangssignals mit einem Rauschpegel des zweiten Empfangssignals verglichen. Beispielsweise kann die Amplitude oder Energie des Rauschens durch Differenzbildung oder Quotientenbildung verglichen werden. Es ist auch denkbar, das Ergebnis durch Logarithmieren in einem größeren dynamischen Bereich darzustellen. Auch wäre es denkbar, eine spektrale Verteilung der Energie des Rauschens zu betrachten, die durch eine Veränderung einer Resonanzfrequenz durch die Verstimmeinrichtung verursacht wird.

Der Vergleich zweier Empfangssignale mit aktivierter und mit dektivierter Verstimmeinrichtung erlaubt es auf einfache Weise, eine Funktion der aktiven Teile der Verstimmeinrichtung zu überprüfen.

In einer denkbaren Ausführungsform des erfindungsgemäßen Verfahrens nach Anspruch 1 sendet ein Sender des Magnetresonanztomographen während der Schritte des Empfangens des ersten Empfangssignals und des zweiten Empfangssignals ein Kleinsignal aus. Als Kleinsignal wird es angesehen, wenn die Amplitude des Prüfpulses ausreichend gering ist, um im Fall eines Defektes der Lokalspule Folgeschäden an der Lokalspule oder Gefahren für den Patienten auszuschließen und den Empfänger nicht zu übersteuern. Das Kleinsignal bzw. der Prüfpuls muss daher eine geringe bzw. reduzierte Leistung aufweisen. Als reduzierte Leistung wird dabei eine Leistung von weniger als 0,1 Watt, 1 Watt oder 5 Watt angesehen. Die reduzierte Leistung kann ebenso durch die Amplitude eines an einer Sendeantenne anstehenden Prüfpulses angegeben sein, wobei typischerweise die effektive Spannung kleiner als 0,5 V, 1 V, 5V oder 15V ist. Beispielsweise kann eine separate Signalquelle als Sender zum Erzeugen des Kleinsignals vorgesehen sein.

Indem das Kleinsignal nicht den Empfänger übersteuert, ist es mit dem erfindungsgemäßen Verfahren vorteilhaft möglich, im Vergleich des ersten Empfangssignals und des zweiten Empfangssignals auch kleine Unterschiede wie beispielsweise eine geringfügige Abschwächung oder eine Änderung einer spektralen Verteilung zu erkennen.

In einer möglichen Ausführungsform des erfindungsgemäßen Verfahrens nach Anspruch 1 ist der Sender zum Erzeugen von Anregungspulsen des Magnetresonanztomographen zum Erzeugen des Kleinsignals vorgesehen. Er weist dazu eine schaltbare Dämpfungseinrichtung zwischen einer Signalerzeugung und einer Leistungsendstufe auf, welche ausgelegt ist, während der Schritte des Empfangens ein Eingangssignal der Leistungsendstufe so zu dämpfen, dass der Sender den Empfänger nicht übersteuert. Der Sender muss dazu eine entsprechend lineare Schaltungstechnik aufweisen, um auch entsprechend kleine Signalstärken proportional und mit ausreichend kleinen Verzerrungen und Rauschen zu erzeugen zu können. Die schaltbare Dämpfungsvorrichtung kann beispielsweise vorgesehen sein, das Eingangssignal um 40 dB, 60 dB, 80 dB, 100 dB oder mehr abzusenken, sodass der Sender auch ein entsprechend abgesenktes Ausgangssignal erzeugt. Es wäre aber auch möglich, ausgangsseitig ein entsprechendes Dämpfungsglied vorzusehen, sodass die Anforderungen an die Linearität der Leistungsendstufe reduziert sind.

Auf vorteilhafte Weise ermöglicht die Verwendung des Senders zum Erzeugen der Anregungspulse beim Überprüfen der Verstimmeinrichtung eine einfache Integration der Tests in eine vorhandene Hardware.

In einer denkbaren Ausführungsform des erfindungsgemäßen Verfahrens nach Anspruch 1 ist der Sender zum Erzeugen von Anregungspulsen des Magnetresonanztomographen auch zum Erzeugen des Kleinsignals vorgesehen. Dabei wird während des Schritts des Empfangens des ersten Empfangssignal und des Empfangens des zweiten Empfangssignals an der Leistungsendstufe kein Eingangssignal zugeführt wird. Mit anderen Worten, die Erzeugung des Anregungssignals wird unterbrochen oder ein Signal mit konstantem Ausgangswert erzeugt. Denkbar ist es beispielsweise die Verbindung zwischen einer Signalerzeugung und der Leistungsendstufe zu unterbrechen oder den Eingang der Leistungsendstufe mit einem konstanten Potential zu verbinden. Die Leistungsendstufe erzeugt dann ein Rauschen am Ausgang, welches als Kleinsignal in dem Prüfverfahren ausgesendet wird.

Die Verwendung des Rauschens der Leistungsendstufe ermöglicht es auch ohne Modifikationen des Senders erfindungsgemäß ein Kleinsignal mit dem Sender zu erzeugen und abzustrahlen und erleichtert dadurch die Implementierung eines erfindungsgemä-βen Prüfverfahrens besonders.

Im Verfahren nach Anspruch 5 ist während der Schritte des Empfangens des ersten Empfangssignals und des zweiten Empfangssignals eine Signalquelle als Sender, vorzugsweise für das Kleinsignal, im Patiententunnel des Magnetresonanztomographen angeordnet. Die Signalquelle sendet ein Signal, vorzugsweise ein Kleinsignal, aus, wobei sich die Leistung des Signals zwischen dem Schritt des

Empfangens des ersten Empfangssignals und dem Schritt des Empfangens des zweiten Empfangssignals um eine vorbestimmte Größe ändert. Vorzugsweise ist die Frequenz des hochfrequenten Wechselfeldes gleich der Larmorfrequenz oder in einem Bereich nahe der Larmorfrequenz.

Eine vorbestimmte Größenänderung des Signals bzw. Kleinsignals gibt auf vorteilhafte Weise eine Möglichkeit, das Signal bzw. Kleinsignal zu identifizieren und/oder Hintergrundsignale zu eliminieren. Darüber hinaus können beispielsweise durch ein nichtlineares Verhalten der Empfangssignale auch die Wirksamkeit passiver Elemente der Verstimmeinrichtung überprüft werden.

In einer denkbaren Ausführungsform des erfindungsgemäßen Verfahrens nach Anspruch 5 erzeugt ein aktiver Sender des Magnetresonanztomographen das Signal. Als aktiver Sender wird hierbei ein Sender bzw. Oszillator angesehen, der nicht nur eine eingestrahlte Hochfrequenz reflektiert oder als hochfrequenten Strom in einem Resonanzkreis oder in einem angeregten Quantenzustand zwischenspeichert und anschließend aussendet, sondern ein Hochfrequenzsignal aus einem von einer Energiequelle über einen elektrischen Leiter zugeführten Strom erzeugt. Das Signal ist ein Kleinsignal, das den Empfänger nicht übersteuert. Eine Prüfsteuerung steuert den Sender in einem Schritt an, die Leistung zu verändern. Beispielsweise kann eine Prüfsteuerung eine Verstärkung in dem Sender zwischen dem Empfangen des ersten Empfangssignals und dem Empfangen des zweiten Empfangssignals vergrößern oder verkleinern. Denkbar ist es auch, dass die Prüfsteuerung eine Amplitude eines Eingangssignals des Senders verändert.

Durch die Prüfsteuerung kann das Signal auf vorbestimmte Weise verändert werden, sodass auf vorteilhafte Weise Amplituden eingestellt werden können, auf denen sich die Verstimmeinrichtung und deren korrekte Funktion auf verschiedene Weise, z.B. durch Nichtlinearität oder eine vorbestimmte Dämpfung oder Energieaufnahme bemerkbar macht.

In einer möglichen Ausführungsform des erfindungsgemäßen Verfahrens nach Anspruch 5 ist der Sender eine passive Signalquelle, beispielsweise ein Resonator oder auch ein Objekt mit Kernspins, die durch ein hochfrequentes Anregungssignal des Magnetresonanztomographen temporär zur Emission eines magnetischen Wechselfelds angeregt werden, dass dann durch die Dämpfung auf vorbestimmte Weise exponentiell mit der Zeit abfällt. Auf diese Weise wird zwischen dem Schritt des Empfangens des ersten Empfangssignals und dem Schritt des Empfangens des zweiten Empfangssignals ein zeitlich abfallendes Hochfrequenzsignal bzw. Magnetresonanzsignal als Kleinsignal erzeugt.

Eine passive Signalquelle als Sender erfordert auf vorteilhafte Weise keine oder nur minimale Veränderungen an dem Magnetresonanztomographen und kann dennoch ein Prüfsignal im erwünschten Frequenzbereich der Larmorfrequenz und mit kleiner, für die Empfänger geeigneter Amplitude bereitstellen.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomo-graphen mit einer erfindungsgemäßen Lokalspule;
- Fig. 2: eine schematische Darstellung einer Prüfeinrichtung eines erfindungsgemäßen Magnetresonanztomographen;
- Fig. 3: ein schematisches Ablaufdiagramm für ein beispielhaftes erfindungsgemäßes Verfahren.

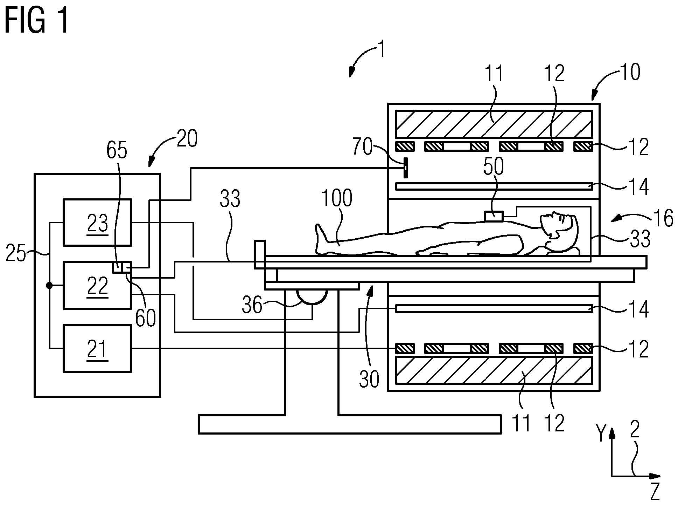

Fig. 1 zeigt eine schematische Darstellung einer Ausführungsform eines Magnetresonanztomographen 1 mit einer erfindungsgemäßen Lokalspule 50.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Anschlussleitung 33 mit der Hochfrequenzeinheit 22 und deren Empfänger 65 verbunden ist.

Durch unmittelbare Nähe zu dem Patienten geht von einer defekten Lokalspule 50 eine besondere Gefahr aus, wenn beispielsweise eine Verstimmeinrichtungen zum Verstimmen der Lokalspule 50 defekt ist und während des Anregungspulses zu hohe Spannungen und/oder Ströme in der Lokalspule induziert werden. Auch ist die Lokalspule 50 wegen permanenten Bewegens, Ansteckens und Lösen der Verbindung besonders anfällig für Defekte. Es ist daher von Vorteil, wenn Lokalspule 50 zumindest vor jeder Bilderfassung in ihren wesentlichen Funktionen in der zur Bilderfassung vorgesehenen Konfiguration mit dem Magnetresonanztomographen getestet wird.

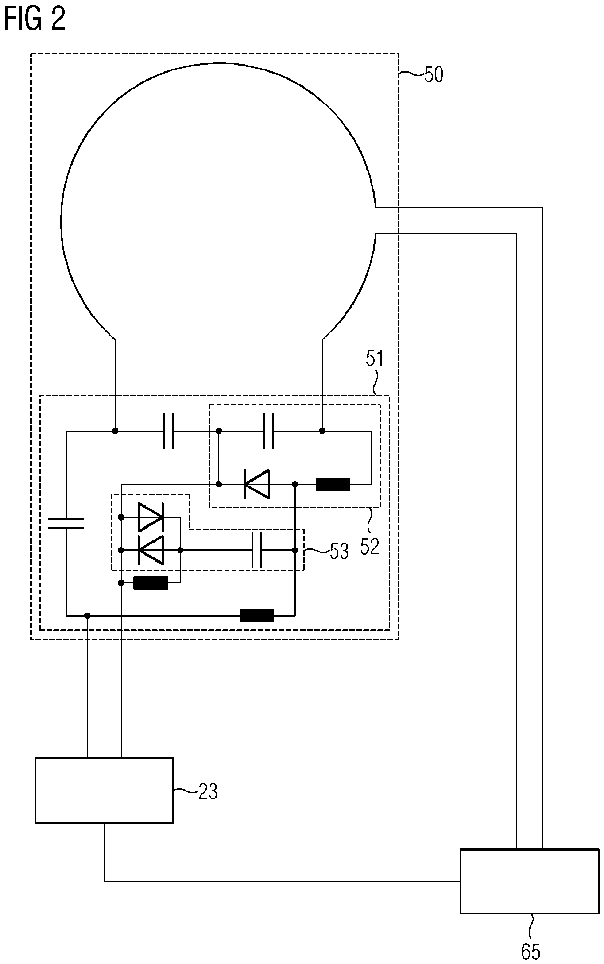

In Fig. 2 sind die für das erfindungsgemäße Verfahren in unterschiedlichen Ausführungsformen wesentlichen Elemente der Prüfeinrichtung schematisch dargestellt.

Die Lokalspule 50 weist eine Verstimmeinrichtung 51 auf, um zu verhindern, dass in einer Antennenspule der Lokalspule 50 während eines Anregungspulses für die Kernspins durch Induktion zu große Ströme fließen und/oder zu große Spannungen induziert werden, die die Lokalspule schädigen und insbesondere durch Spannung oder Wärmeentwicklung auch den Patienten gefährden können. Vorzugsweise weist die Verstimmeinrichtung 50 dazu sowohl eine passive Verstimmung 53 als auch eine aktive Verstimmung 52 auf. Die passive Verstimmung erfolgt beispielsweise durch zwei antiparallel geschaltete Dioden, sodass in dem Fall, dass die induzierte Wechselspannung die Schwellspannung der Dioden überschreitet, diese leitend werden und ein zusätzliches LC-Glied in Serie in die Antennenspule einschleifen, wodurch die Resonanzfrequenz geändert und die induzierte Spannung begrenzt wird.

Die aktive Verstimmung 52 erfolgt durch eine PIN-Diode, die von der Steuerung mit einer Sperrspannung und/oder einem Vorwärtsstrom beaufschlagt werden kann, sodass eine Verstimmung entweder durch die veränderte Sperrschichtkapazität oder durch die Schaltwirkung in Verbindung mit einer in Serie oder parallel geschalteten Kapazität und/oder Induktivität erfolgt.

Es sind dabei auch andere Schaltungen und Kombinationen der Elemente der Verstimmeinrichtung 51 denkbar. Beispielsweise ist es auch möglich, aktive Verstimmung 52 und passive Verstimmung 53 separat ohne gemeinsame Pfade oder Bauelemente auszuführen. Es ist insbesondere Aufgabe des erfindungsgemäßen Verfahrens und des erfindungsgemäßen Magnetresonanztomographen, die Funktion möglichst vieler bzw. aller Komponenten überprüfen zu können.

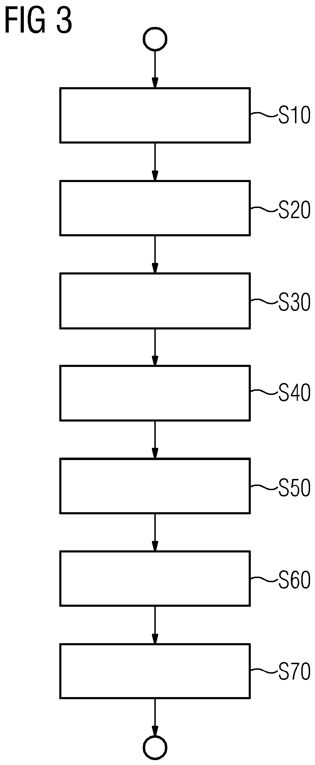

In Fig. 3 ist das erfindungsgemäße Verfahren schematisch in einem Anlaufdiagramm dargestellt.

Zum erfindungsgemäßen Verfahren ist es vorgesehen, dass in einem Schritt S10 die Verstimmeinrichtung der Antennenspule, beispielsweise der Lokalspule 50 durch eine Prüfsteuerung aktiviert wird. Die Prüfsteuerung kann dabei die Steuerung 23 des Magnetresonanztomographen 1 sein, realisiert durch ein entsprechendes Programm oder Programmmodul. Denkbar sind aber auch dedizierte Prozessoren oder eine Logikschaltung wie ein FPGA. Beim Aktivieren wird eine aktive Verstimmung 52 so ansteuert, dass eine mit der aktiven Verstimmung 52 in elektrischer Verbindung stehende Lokalspule 50 oder beispielsweise auch eine Körperspule 14 im aktivierten Zustand nicht mehr auf der für den Empfangsfall optimalen Frequenz eine Resonanz aufweist. Üblicherweise ist die optimale Frequenz die Larmorfrequenz der zu untersuchenden Kernspins in dem statischen Magnetfeld B0 des Magnetresonanztomographen 1. Das Aktivieren der aktiven Verstimmung 52 kann in unterschiedlichen Ausführungsformen des erfindungsgemäßen Verfahrens zu unterschiedlichen Zeitpunkten erfolgen und nicht nur wie in Fig. 3 dargestellt am Anfang.

Den unterschiedlichen Ausführungsformen des erfindungsgemäßen Verfahrens ist gemeinsam, dass zu zwei unterschiedlichen Zeitpunkten in einem Schritt S20 und in einem Schritt S50 ein zweites Empfangssignal mit einem Empfänger S50 empfangen werden. Als unterschiedliche Zeitpunkte wird dabei angesehen, wenn beispielsweise ein weiterer Schritt des Verfahrens zwischen Schritt S20 und S50 erfolgt oder zumindest das empfangene Signal sich durch physikalische Gegebenheiten zwischen den Schritten S20 und S50 verändert, beispielsweise aufgrund einer Dämpfung oder einer abklingenden Anregung. Die beiden Zeitpunkte der Schritte S20 und S50 unterscheiden sich daher beispielsweise um mehr als 1 ms, 5 ms, 10 ms, 50 ms oder 100 ms .

In einem Schritt S60 werden von der Prüfsteuerung das erste Empfangssignal mit dem zweiten Empfangssignal verglichen. Als Vergleichen kann beispielsweise eine Differenzbildung der Amplituden oder Amplitudenquadrate beider Empfangssignale angesehen werden. Denkbar wären auch eine Phasendifferenzbildung oder eine spektrale Analyse der Energieverteilung über mehrere oder viele Frequenzen. Auch darauf angewandte Funktionen wie Logarithmenbildung können ein Teil des Vergleichens sein.

Schließlich wird in einem Schritt S70 ein Warnsignal ausgegeben, wenn das Ergebnis des Vergleichs nicht mit einer vorbestimmten Relation für das erste Empfangssignals zu dem zweiten Empfangssignal übereinstimmt. Nachfolgend sind einzelne Beispiele für Signale und erwartete vorbestimmte Relationen angegeben. Das Warnsignal kann einem Bediener über eine Ausgabe ausgegeben werden oder auch direkt an die Steuereinheit 20, sodass diese beispielsweise die weitere Bilderfassung unterbricht, um einen Patienten 100 nicht durch eine defekte Verstimmeinrichtung 51 zu gefährden.

Im erfindungsgemäßen Verfahren nach Anspruch 1 ist es vorgesehen, dass in einem Schritt S30 die Verstimmeinrichtung von der Prüfsteuerung deaktiviert wird. Eines der beiden Empfangssignale wird so bei aktivierter aktiver Verstimmung 52 empfangen, während das andere Empfangssignal bei deaktivierter aktiver Verstimmung 52 empfangen wird. Der Schritt S10 kann beispielsweise vor Schritt S20 erfolgen und der Schritt S30 zwischen Schritt S20 und S50. Dabei ist es vorgesehen, dass der Magnetresonanztomograph 1 während der Schritte S20 und S50 kein aktives Signal aussendet, mit anderen Worten die Hochfrequenzeinheit 22 und/oder ein Prüfsender 60 nicht mit einem Eingangssignal angesteuert werden. Das Empfangssignal wird daher beispielsweise durch ein Rauschsignal einer Endstufe des Senders charakterisiert. In dem Schritt S60 des Vergleichens werden daher der Rauschpegel des ersten Empfangssignals mit dem Rauschpegel des zweiten Empfangssignals verglichen. Durch die aktive Verstimmung 52 ist es beispielsweise denkbar, dass sich der Pegel und die Energie des von dem Empfänger 65 empfangenen Empfangssignals auf charakteristische Weise ändern. Dies kann verbunden bzw. verursacht sein durch eine veränderte Resonanzfrequenz der Antenne bzw. Lokalspule 50. Es wäre daher auch denkbar, für den Vergleich eine Veränderung der spektralen Verteilung des Rauschsignals z.B. mittels FFT zu betrachten, die sich durch eine Faltung von Spektrum der Rauschquelle mit Resonanzfrequenz der Antenne ergibt, die wiederum durch die aktive Verstimmung verändert wird. Auf vorteilhafte Weise ist das Rauschsignal in der Amplitude so klein, dass eine passive Verstimmung 53 nicht in Erscheinung tritt und so allein die Funktion der aktiven Verstimmung 52 geprüft werden kann.

Es ist in einer Ausführungsform des erfindungsgemäßen Verfahrens nach Anspruch 1 aber auch denkbar, dass ein Sender des Magnetresonanztomographen während der Schritte des Empfangens S20, S50 ein Kleinsignal aussendet, welches ausgelegt ist, den Empfänger nicht zu übersteuern.

Der Sender kann zum einen der Sender sein, der von dem Magnetresonanztomographen genutzt wird, die Anregungspulse für die Kernspins bei der Bilderfassung zu erzeugen. Üblicherweise ist der Sender jedoch dazu ausgelegt, extrem starke Hochfrequenzimpulse im Bereich von einigen hundert bis zu tausenden von Watt mit hoher Effizienz zu erzeugen. Um Kleinsignale zu erzeugen, die den Empfänger 65 nicht übersteuern kann der Magnetresonanztomograph eine Linearendstufe aufweisen und eine schaltbare Dämpfungseinrichtung zwischen einer Signalerzeugung und der Linearendstufe, die während der Schritte des Empfangens S20, S50 ein Eingangssignal der Linearendstufe ausreichend dämpft, um ein entsprechendes Kleinsignal am Ausgang der Linearendstufe zu erzeugen. Grundsätzlich wäre es auch denkbar, das Ausgangssignal einer konventionellen Leistungsendstufe zu dämpfen, wobei jedoch eine hohe Leistung als Verlustleistung des Dämpfungsgliedes abgeführt werden müsste.

Das erzeugte Kleinsignal kann beispielsweise über die Körperspule 14 als Sendeantenne in den Patiententunnel 16 mit der Lokalspule 50 als Empfangsantenne emittiert werden.

Denkbar wäre aber auch ein separater Prüfsender 60 als Teil des erfindungsgemäßen Magnetresonanztomographen 1, der gesteuert von der Prüfsteuerung das Kleinsignal erzeugt und über eine Sendeantenne 70 in den Patiententunnel 16 mit der Lokalspule 50 emittiert.

Eine aktive Erzeugung des Kleinsignals gibt in dem erfindungsgemäßen Verfahren nach Anspruch 5 mehr Freiheitsgrade beim Vergleich des ersten Empfangssignals und des zweiten Empfangssignals, indem die Leistung und vorzugsweise auch das Frequenzspektrum zwischen Schritt S20 und Schritt S50 verändert wird. Beispielsweise kann die Leistung des Kleinsignals zwischen Schritt S20 und S50 so stark verändert werden, dass bei der größeren Leistung bereits die passive Verstimmung 53 eingreift und der Pegel des Empfangssignals begrenzt wird. Die Funktion der passiven Verstimmung 53 kann anhand dieser Begrenzung oder einer Nichtlinearität bei drei oder mehr Messwerten überprüft werden.

Auch wäre es denkbar zusätzlich zur Leistung eine spektrale Verteilung des Kleinsignals zwischen den Schritten zu verändern, um eine Funktion einer aktiven Verstimmung 52 und/oder passiven Verstimmung 53 zu prüfen. Hier sind verschiedene Kombinationen aus unterschiedlichen Kleinsignalen und Einstellungen der aktiven Verstimmung denkbar, die alle Funktionen der Verstimmeinrichtung 51 überprüfen.

Denkbar wäre es auch, die Kernspins selbst nach einer Anregung als Kleinsignalquelle zu nutzen. Beispielsweise könnte ein Messwert aus einer vorhergehenden Bilderfassungssequenz genutzt werden, um ein zu erwartendes Magnetresonanzsignal in Stärke sowie dessen zeitlichen Verlauf abzuschätzen. Denkbar wäre bei bekannter Spindichte und Anregungssignal eine Bloch-Simulation des zu erwartenden Magnetresonanzsignals. Ein typischer Verlauf ist dabei ein exponentieller Abfall des Magnetresonanzsignals. Von diesem Kleinsignal mit bekanntem zeitlichen Verlauf lassen sich die bereits beschriebenen Schritte ebenfalls ausführen, insbesondere eine Prüfung der aktiven Verstimmung 53, die im Gegensatz zur passiven Verstimmung keine Mindestamplitude des Kleinsignals für das Ansprechen der Verstimmung erfordert.

Die Kernspins könnten dabei auch über ein Phantom bereitgestellt werden. Denkbar wäre es bei geringer Signalstärke auch, den Patienten als Quelle des Magnetresonanzsignals zu nutzen. Es wären aber auch passive Resonatoren denkbar wie ein Schwingkreis oder Dipol, die durch einen Anregungspuls der Hochfrequenzeinheit 22 angeregt werden und einen von der Güte des Schwingkreises bzw. Dipols vorbestimmten exponentiellen Signalabfall aufweisen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Verfahren zum Überprüfen einer Verstimmeinrichtung (51) einer Antennenspule eines Magnetresonanztomographen (1), wobei das Verfahren die Schritte aufweist:
(S10) Aktivieren der Verstimmeinrichtung (51) der Antennenspule;
(S20) Empfangen eines ersten Empfangssignals mit einem Empfänger (65);
(S50) Empfangen eines zweiten Empfangssignals mit dem Empfänger(65);
(S60) Vergleichen des ersten Empfangssignals mit dem zweiten Empfangssignals durch eine Prüfsteuerung;
(S70) Ausgeben eines Warnsignals, wenn das Ergebnis des Vergleichs nicht mit einer vorbestimmten Relation für das erste Empfangssignals zu dem zweiten Empfangssignal übereinstimmt,
wobei das Verfahren einen Schritt (S30) aufweist, die Verstimmeinrichtung (51) zu deaktivieren, wobei der Schritt (S50) des Empfangens des zweiten Empfangssignals bei abgeschalteter Verstimmeinrichtung (51) erfolgt und in dem Schritt (S60) des Vergleichens ein Rauschpegel des ersten Empfangssignals mit einem Rauschpegel des zweiten Empfangssignals verglichen wird, wobei
das erste und das zweite Empfangssignal jeweils ein hochfrequentes Strom- und/oder Spannungssignal ist, das analog oder digitalisiert den Empfänger erreicht und Information zu Amplitude, Phase und/oder spektraler Verteilung aufweist.

2. Verfahren nach Anspruch 1, wobei ein Sender des Magnetresonanztomographen während der Schritte des Empfangens (S20, S50) ein Kleinsignal aussendet, welches ausgelegt ist, den Empfänger (65) nicht zu übersteuern.

3. Verfahren nach Anspruch 2, wobei der Sender zum Erzeugen von Anregungspulsen des Magnetresonanztomographen vorgesehen ist und eine schaltbare Dämpfungseinrichtung zwischen einer Signalerzeugung und einer Leistungsendstufe aufweist, welche ausgelegt ist, während der Schritte des Empfangens (S20, S50) ein Eingangssignal der Leistungsendstufe so zu dämpfen, dass der Sender den Empfänger (65) nicht übersteuert.

4. Verfahren nach Anspruch 2, wobei der Sender zum Erzeugen von Anregungspulsen des Magnetresonanztomographen (1) vorgesehen ist und während der Schritte des Empfangens (S20, S50) kein Eingangssignal an der Leistungsendstufe zugeführt wird.

5. Verfahren zum Überprüfen einer Verstimmeinrichtung (51) einer Antennenspule eines Magnetresonanztomographen (1), wobei das Verfahren die Schritte aufweist:
(S10) Aktivieren der Verstimmeinrichtung (51) der Antennenspule;
(S20) Empfangen eines ersten Empfangssignals mit einem Empfänger (65);
(S50) Empfangen eines zweiten Empfangssignals mit dem Empfänger(65);
(S60) Vergleichen des ersten Empfangssignals mit dem zweiten Empfangssignals durch eine Prüfsteuerung;
(S70) Ausgeben eines Warnsignals, wenn das Ergebnis des Vergleichs nicht mit einer vorbestimmten Relation für das erste Empfangssignals zu dem zweiten Empfangssignal übereinstimmt,
wobei während der Schritte des Empfangens (S20, S50) eine Signalquelle in einem Patiententunnel (16) des Magnetresonanztomographen (1) angeordnet ist und ein Signal aussendet, wobei sich die Leistung des Signals zwischen dem Schritt (S20) des Empfangens des ersten Empfangssignals und dem Empfangen des zweiten Empfangssignals um eine vorbestimmte Größe ändert,
wobei das erste und das zweite Empfangssignal jeweils ein hochfrequentes Strom- und/oder Spannungssignal ist, das analog oder digitalisiert den Empfänger erreicht und Information zu Amplitude, Phase und/oder spektraler Verteilung aufweist.

6. Verfahren nach Anspruch 5, wobei ein Sender des Magnetresonanztomographen (1) als Signalquelle das Signal erzeugt und das Signal ein Kleinsignal ist, das den Empfänger (65) nicht übersteuert und eine Prüfsteuerung den Sender in einem Schritt (S40) ansteuert, die Leistung zu verändern.

7. Verfahren nach Anspruch 5, wobei die Signalquelle eine passive Signalquelle ist, die von dem Magnetresonanztomographen (1) zum Aussenden des Kleinsignals angeregt wird, wobei zwischen dem Schritt (S20) des Empfangens des ersten Empfangssignals und dem Schritt (S50) des Empfangens des zweiten Empfangssignals eine Amplitude des von der Signalquelle emittierten Kleinsignals auf vorbestimmte Weise zeitlich abfällt.

8. Magnetresonanztomograph mit einer Prüfeinrichtung zum Prüfen einer Verstimmeinrichtung (51) einer Antennenspule des Magnetresonanztomographen (1), wobei die Prüfeinrichtung eine Prüfsteuerung aufweist und die Prüfsteuerung ausgelegt ist, die Verstimmeinrichtung (51) der Antennenspule zu aktivieren; ein erstes Empfangssignal mit einem Empfänger (65) zu empfangen;
ein zweites Empfangssignal mit dem Empfänger (65) zu empfangen;
das erste Empfangssignal mit dem zweiten Empfangssignal zu vergleichen und ein Warnsignal auszugeben, wenn das Ergebnis des Vergleichs nicht mit einer vorbestimmten Relation für das erste Empfangssignal zu dem zweiten Empfangssignal übereinstimmt,
wobei der Magnetresonanztomograph (1) einen Sender zum Erzeugen von Anregungspulsen mit einer schaltbaren Dämpfungseinrichtung aufweist und die Prüfsteuerung ausgelegt ist, während der Schritte des Empfangens (S20, S50) des ersten Empfangssignals und/oder zweiten Empfangssignals ein Kleinsignal mit Hilfe des Senders und der Dämpfungseinrichtung auszusenden, welches ausgelegt ist, den Empfänger (65) nicht zu übersteuern, wobei die Prüfsteuerung ausgelegt ist, die Verstimmeinrichtung (51) zu deaktivieren, wobei die Prüfsteuerung ausgelegt ist, den Schritt (S50) des Empfangens des zweiten Empfangssignals bei abgeschalteter Verstimmeinrichtung (51) auszuführen und in dem Schritt (S60) des Vergleichens einen Rauschpegel des ersten Empfangssignals mit einem Rauschpegel des zweiten Empfangssignals zu vergleichen, wobei
das erste und das zweite Empfangssignal jeweils ein hochfrequentes Strom- und/oder Spannungssignal ist, das analog oder digitalisiert den Empfänger erreicht und Information zu Amplitude, Phase und/oder spektraler Verteilung aufweist.

9. Magnetresonanztomograph mit einer Prüfeinrichtung zum Prüfen einer Verstimmeinrichtung (51) einer Antennenspule des Magnetresonanztomographen (1), wobei die Prüfeinrichtung eine Prüfsteuerung aufweist und die Prüfsteuerung ausgelegt ist, die Verstimmeinrichtung (51) der Antennenspule zu aktivieren;
ein erstes Empfangssignal mit einem Empfänger (65) zu empfangen;
ein zweites Empfangssignal mit dem Empfänger (65) zu empfangen; das erste Empfangssignal mit dem zweiten Empfangssignal zu vergleichen und ein Warnsignal auszugeben, wenn das Ergebnis des Vergleichs nicht mit einer vorbestimmten Relation für das erste Empfangssignal zu dem zweiten Empfangssignal übereinstimmt,
wobei der Magnetresonanztomograph (1) eine aktive Signalquelle aufweist, die während der Schritte des Empfangens (S20, S50) in einem Patiententunnel (16) des Magnetresonanztomographen (1) angeordnet ist und dazu ausgelegt ist, ein Signal auszusenden,
wobei die Prüfsteuerung ausgelegt ist, die Leistung des Signals zwischen dem Schritt (S20) des Empfangens des ersten Empfangssignals und dem Schritt (S50) des Empfangens des zweiten Empfangssignals um eine vorbestimmte Größe zu ändern, wobei das erste und das zweite Empfangssignal jeweils ein hochfrequentes Strom- und/oder Spannungssignal ist, das analog oder digitalisiert den Empfänger erreicht und Information zu Amplitude, Phase und/oder spektraler Verteilung aufweist.

## Claims

1. Method for checking a detuning facility (51) of an antenna coil of a magnetic resonance tomography unit (1), wherein the method comprises the steps:
(S10) Activating the detuning facility (51) of the antenna coil;
(S20) Receiving a first receive signal with a receiver (65);
(S50) Receiving a second receive signal with the receiver (65) ;
(S60) Comparing the first receive signal with the second receive signal by means of a test controller;
(S70) Outputting a warning signal if the result of the comparison does not match a predetermined relation for the first receive signal to the second receive signal,
wherein the method has a step (S30) of deactivating the detuning facility (51), wherein the step (S50) of receiving the second receive signal takes place with the detuning facility (51) switched off and in the step (S60) of comparing, a noise level of the first receive signal is compared with a noise level of the second receive signal, wherein the first and the second receive signal is in each case a high-frequency current and/or voltage signal which reaches the receiver in an analogue or digitised manner and has information relating to amplitude, phase and/or spectral distribution.

2. Method according to claim 1, wherein a transmitter of the magnetic resonance tomography unit emits a small signal during the steps of receiving (20, S50), which small signal is designed not to override the receiver (65).

3. Method according to claim 2, wherein the transmitter is provided for generating excitation pulses of the magnetic resonance tomography unit and has a switchable attenuating facility between signal generation and a power output stage, which is designed to damp an input signal of the power output stage during the steps of receiving (S20, S50) such that the transmitter does not override the receiver (65)

4. Method according to claim 2, wherein the transmitter is provided for generating excitation pulses of the magnetic resonance tomography unit (1) and during the steps of receiving (S20, S50) no input signal is supplied to the power output stage.

5. Method for checking a detuning facility (51) of an antenna coil of a magnetic resonance tomography unit (1), wherein the method comprises the steps:
(S10) Activating the detuning facility (51) of the antenna coil;
(S20) Receiving a first receive signal with a receiver (65);
(S50) Receiving a second receive signal with the receiver (65) ;
(S60) Comparing the first receive signal with the second receive signal by a test controller;
(S70) Outputting a warning signal if the result of the comparison does not match a predetermined relation for the first receive signal to the second receive signal,
wherein during the steps of receiving (S20, S50) a signal source is arranged in a patient tunnel (16) of the magnetic resonance tomography unit (1) and emits a signal, wherein the power of the signal between the step (S20) of receiving the first receive signal and receiving the second receive signal changes by a predetermined magnitude, wherein the first and the second receive signal is in each case a high-frequency current and/or voltage signal, which reaches the receiver in an analogue or digitised manner and has information relating to the amplitude, phase and/or spectral distribution.

6. Method according to claim 5, wherein a transmitter of the magnetic resonance tomography unit (1) generates the signal as a signal source and the signal is a small signal which does not override the receiver (65) and a test controller actuates the transmitter in a step (S40) to change the power.

7. Method according to claim 5, wherein the signal source is a passive signal source which is excited by the magnetic resonance tomography unit (1) for emitting the small signal, wherein between the step (S20) of receiving the first receive signal and the step (S50) of receiving the second receive signal, an amplitude of the small signal emitted by the signal source decreases over time in a predetermined manner.

8. Magnetic resonance tomography unit having a testing facility for testing a detuning facility (51) of an antenna coil of the magnetic resonance tomography unit (1), wherein the testing facility has a test controller and the test controller is designed to activate the detuning facility (51) of the antenna coil;
to receive a first receive signal with a receiver (65);
to receive a second receive signal with the receiver (65);
to compare the first receive signal to the second receive signal and to output a warning signal if the result of the comparison does not match a predetermined relation for the first receive signal to the second receive signal,
wherein the magnetic resonance tomography unit (1) has a transmitter for generating excitation pulses with a switchable attenuating facility and during the steps of receiving (S20, S50) the first receive signal and/or second receive signal, the test controller is designed to emit a small signal with the aid of the transmitter and the attenuating facility, which small signal is designed not to override the receiver (65), wherein the test controller is designed to deactivate the detuning facility (51), wherein the test controller is designed to execute the step (S50) of receiving the second receive signal when the detuning facilty (51) is switched off and in the step (S60) of comparing, to compare a noise level of the first receive signal with a noise level of the second receive signal, wherein the first and the second receive signal is in each case a high-frequency current and/or voltage signal, which reaches the receiver in an analogue or digitised manner and has information relating to amplitude, phase and/or spectral distribution.

9. Magnetic resonance tomography unit with a testing facility for testing a detuning facility (51) of an antenna coil of the magnetic resonance tomography unit (1), wherein the testing facility has a test controller and the test controller is designed to activate the detuning facility (51) of the antenna coil; to receive a first receive signal with a receiver (65); to receive a second receive signal with the receiver (65); to compare the first receive signal with the second receive signal and to output a warning signal, if the result of the comparison does not match a predetermined relation for the first receive signal to the second receive signal, wherein the magnetic resonance tomography unit (1) has an active signal source which is arranged in a patient tunnel (16) during the steps of receiving (S20, S50) and is designed to emit a signal, wherein the test controller is designed to change the power of the signal between the step (S20) of receiving the first receive signal and the step (S50) of receiving the second receive signal by a predetermined magnitude, wherein the first and the second receive signal is in each case a high-frequency current and/or voltage signal, which reaches the receiver in an analogue or digitised manner and has information relating to amplitude, phase and/or spectral distribution.

## Revendications

1. Procédé de contrôle d'un système (51) de désaccord d'une bobine d'antenne d'un tomodensitomètre (1) à résonnance magnétique, dans lequel le procédé comporte les stades :
(S10) Activation du dispositif (51) de désaccord de la bobine d'antenne ;
(S20) Réception d'un premier signal de réception par un récepteur (65) ;
(S50) Réception d'un deuxième signal de réception par le récepteur (65) ;
(S60) Comparaison du premier signal de réception au deuxième signal de réception par une commande de contrôle ;
(S70) Émission d'un signal d'alerte si le résultat de la comparaison ne coïncide pas avec une relation déterminée à l'avance du premier signal de réception au deuxième signal de réception,
dans lequel le procédé a un stade (S30) de désactivation du dispositif (51) de désaccord, dans lequel le stade (S50) de la réception du deuxième signal de réception s'effectue alors que le dispositif (51) de désaccord est mis hors circuit et dans le stade (S60) de la comparaison, on compare un niveau de bruit du premier signal de réception à un niveau de bruit du deuxième signal de réception, dans lequel
le premier et le deuxième signal de réception sont chacun un signal de courant et/ou de tension en haute fréquence, qui atteint analogiquement ou numériquement le récepteur et a une information d'amplitude, de phase et/ou de répartition spectrale.

2. Procédé suivant la revendication 1, dans lequel un émetteur du tomodensitomètre à résonnance magnétique émet pendant les stades de la réception (S20, S50) un signal petit, qui est conçu pour ne pas surcommander le récepteur (65).

3. Procédé suivant la revendication 2, dans lequel l'émetteur est prévu pour la production d'impulsions d'excitation du tomodensitomètre à résonnance magnétique et a un dispositif d'amortissement pouvant être mis en circuit entre une production du signal et un stade de puissance, qui est conçu pour amortir, pendant les stades de la réception (S20, S50), un signal d'entrée de l'étage de puissance, de manière à ce que l'émetteur ne surcommande pas le récepteur (65).

4. Procédé suivant la revendication 2, dans lequel l'émetteur est prévu pour la production d'impulsions d'excitation du tomodensimètre (1) à résonnance magnétique et pendant les stades de la réception (S20, S50), on n'envoie pas de signal d'entrée à l'étage de puissance.

5. Procédé de contrôle d'un système (51) de désaccord d'une bobine d'antenne d'un tomodensitomètre (1) à résonnance magnétique, dans lequel le procédé comporte les stades :
(S10) Activation du dispositif (51) de désaccord de la bobine d'antenne ;
(S20) Réception d'un premier signal de réception par un récepteur (65) ;
(S50) Réception d'un deuxième signal de réception par le récepteur (65) ;
(S60) Comparaison du premier signal de réception au deuxième signal de réception par une commande de contrôle ;
(S70) Émission d'un signal d'alerte si le résultat de la comparaison ne coïncide pas avec une relation déterminée à l'avance du premier signal de réception au deuxième signal de réception,
dans lequel, pendant les stades de la réception (S20, S50), une source de signal est montée dans un tunnel (16) de patient du tomodensitomètre (1) à résonnance magnétique et émet un signal, dans lequel
la puissance du signal, entre le stade (S20) de la réception du premier signal de réception et la réception du deuxième signal de réception, se modifie d'une grandeur déterminée à l'avance, dans lequel le premier et le deuxième signal de réception sont chacun un signal de courant et/ou de tension en haute fréquence, qui atteint analogiquement ou numériquement le récepteur et a une information d'amplitude, de phase et/ou de répartition spectrale.

6. Procédé suivant la revendication 5,
dans lequel un émetteur du tomodensitomètre (1) à résonnance magnétique comme source de signal produit le signal et le signal est un signal petit, qui ne surcommande pas le récepteur (65) et une commande de contrôle commande l'émetteur dans un stade (S40) pour modifier la puissance.

7. Procédé suivant la revendication 5, dans lequel la source de signal est une source de signal passive, que l'on excite par le tomodensitomètre (1) à résonnance magnétique pour l'émission d'un signal petit, dans lequel entre le stade (S20) de la réception du premier signal de réception (S50) de la réception du deuxième signal de réception une amplitude du signal petit émis par la source de signal décroit en fonction du temps d'une façon déterminée à l'avance.

8. Tomodensitomètre à résonnance magnétique comprenant un dispositif de contrôle pour le contrôle d'un dispositif (51) de désaccord d'une bobine d'antenne du tomodensitomètre (1) à résonnance magnétique, dans lequel le dispositif de contrôle a une commande de contrôle et la commande de contrôle est conçue pour activer le dispositif (51) de désaccord de la bobine d'antenne ; recevoir un premier signal de réception par un premier récepteur (65) ; recevoir un deuxième signal de réception par le récepteur (65) ;
comparer la premier signal de réception au deuxième signal de réception et émettre un signal d'alerte si le résultat de la comparaison ne coïncide pas avec une relation définie à l'avance du premier signal de réception au deuxième signal de réception, dans lequel le tomodensitomètre (1) à résonnance magnétique a un émetteur de production d'impulsions d'excitation comprenant un dispositif d'amortissement pouvant être mis en circuit et la commande de contrôle est conçue pour, pendant les stades de la réception (S20, S50) du premier signal de réception et/ou du deuxième signal de réception, émettre un signal petit à l'aide de l'émetteur et du dispositif d'amortissement, qui est conçu pour ne pas surcommander le récepteur (65), dans lequel la commande de contrôle est conçue pour désactiver le dispositif (51) de désaccord, dans lequel la commande de contrôle est conçue pour effectuer le stade (S50) de la réception du deuxième signal de réception alors que le dispositif (51) de désaccord est mis hors circuit et, dans le stade (S60) de la comparaison, pour comparer un niveau de bruit du premier signal de réception à un niveau de bruit du signal de réception, dans lequel
le premier et le deuxième signal de réception sont chacun un signal de courant et/ou de tension en haute fréquence, qui atteint analogiquement ou numériquement le récepteur et a une information d'amplitude, de phase et/ou de répartition spectrale.

9. Tomodensitomètre à résonnance magnétique comprenant un dispositif de contrôle pour le contrôle d'un dispositif (51) de désaccord d'une bobine d'antenne du tomodensitomètre (1) à résonnance magnétique, dans lequel le dispositif de contrôle a une commande de contrôle et la commande de contrôle est conçue pour activer le dispositif (51) de désaccord de la bobine d'antenne ; recevoir un premier signal de réception par un premier récepteur (65) ; recevoir un deuxième signal de réception par le récepteur (65) ;
comparer la premier signal de réception au deuxième signal de réception et émettre un signal d'alerte si le résultat de la comparaison ne coïncide pas avec une relation définie à l'avance du premier signal de réception au deuxième signal de réception, dans lequel le tomodensitomètre (1) à résonnance magnétique a une source de signal active, qui est montée, pendant les stades de la réception (S20, S50), dans un tunnel (16) de patient du tomodensitomètre (1) à résonnance magnétique et qui est conçue pour émettre un signal,
dans lequel la commande de contrôle est conçue pour modifier la puissance du signal entre le stade (S20) de la réception du premier signal de réception et le stade (S50) de la réception du deuxième signal de réception d'une grandeur déterminée à l'avance, dans lequel le premier et le deuxième signal de réception sont chacun un signal de courant et/ou de tension en haute fréquence, qui atteint analogiquement ou numériquement le récepteur et a une information d'amplitude, de phase et/ou de répartition spectrale.
